Europäisches Patentamt

European Patent Office

Office européen des brevets

(19)

(11) Publication number : **0 499 478 A2**

## (12) EUROPEAN PATENT APPLICATION

(21) Application number : 92301223.1

(22) Date of filing : 14.02.92

(51) Int. Cl.$^5$ : **G11C 11/409**, G11C 7/06

(30) Priority : **14.02.91 JP 20212/91**

(43) Date of publication of application :
**19.08.92 Bulletin 92/34**

(84) Designated Contracting States :
**DE FR GB**

(71) Applicant : **SHARP KABUSHIKI KAISHA**
**22-22 Nagaike-cho Abeno-ku**
**Osaka 545 (JP)**

(72) Inventor : **Kubota, Yasushi**
**5-1093-267, Asakuradainishi**
**Sakurai-shi, Nara-ken (JP)**

(74) Representative : **Brown, Kenneth Richard et al**
**R.G.C. Jenkins & Co. 26 Caxton Street**
**London SW1H 0RJ (GB)**

(54) Semiconductor memory unit array.

(57)    A semiconductor memory unit array has a plurality of memory units (M1, M2, ...) aligned in a line. One memory unit (M1) has N-sense amplifier array (4) and P-sense amplifier array (6) connected at opposite ends of bit lines (B1, B1#). Each sense amplifier (NSA1) has one pair of gates (TN0, TN0#) on one side and another pair of gates (TN1, TN1#) on the opposite side. When one pair of gates (TN1, TN1#) close and another pair of gates (TN0, TN0#) open, the sense amplifier located between the two pairs of gates operates in association with the memory cell array (2) connected to the closed gates. In this manner, the sense amplifiers are shared between the neighboring memory cell arrays.

Fig. 2

EP 0 499 478 A2

## BACKGROUND OF THE INVENTION

### 1. Field of the Invention

The present invention relates to a semiconductor memory device, such as a dynamic random access memory (DRAM) device, and more particularly, to a memory unit array using the sense circuit in common between the neighboring units.

### 2. Description of the Prior Art

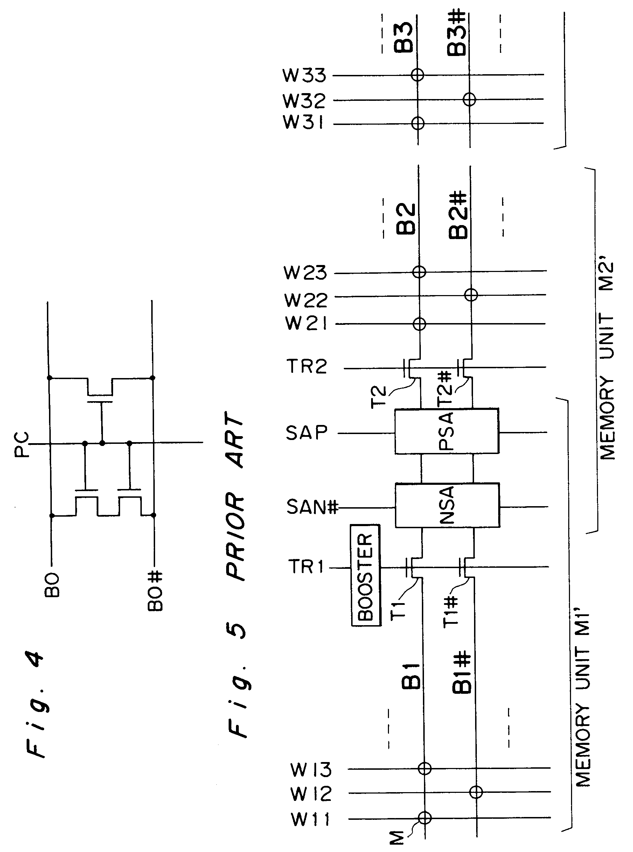

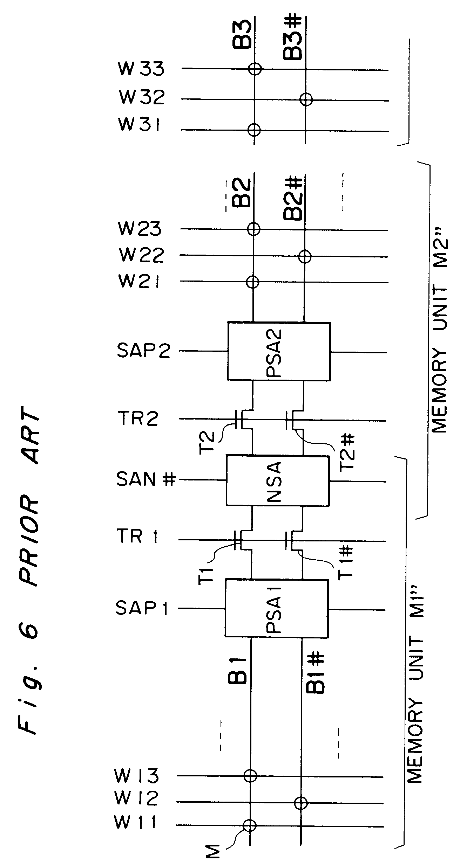

Variations of a conventional semiconductor memory unit array are shown in Figs. 5 and 6. It is to be noted that the bit line precharge circuit and I/O circuit are omitted because only those parts essential to the present invention are discussed.

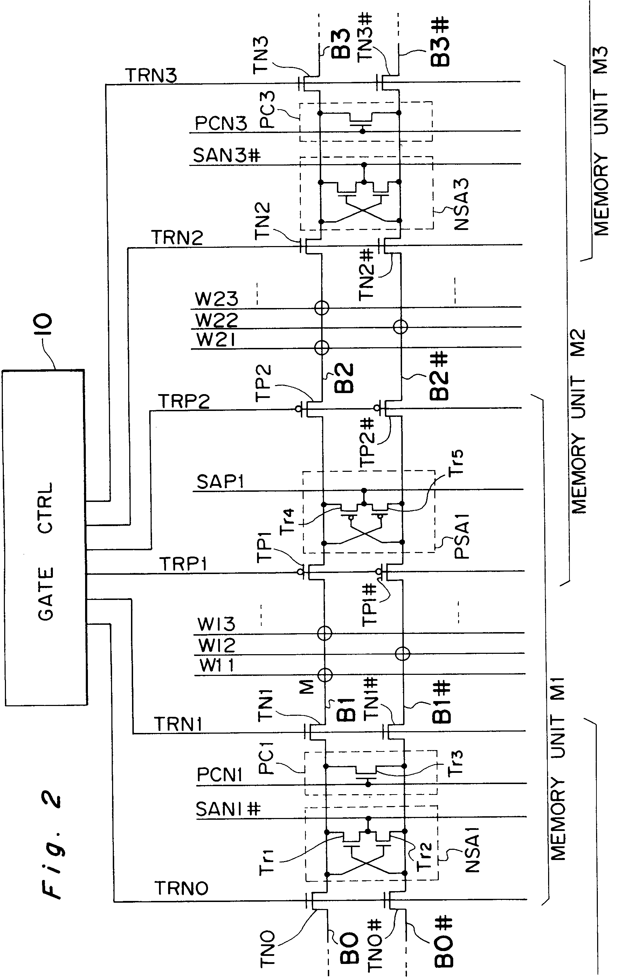

In Figs. 5 and 6, as well as in Fig. 2, only one pair of bit lines and only three word lines are shown for one memory unit, but each memory unit has much more number of pairs of bit lines aligned horizontally and much more number of word lines aligned vertically, when viewed in these drawings.

Generally, one memory unit has a plurality of P- and N-sense amplifiers aligned in an array in the direction parallel to the word lines, and one pair of P- and N-sense amplifiers is used for two bit lines.

According to the first prior art memory unit array shown in Fig. 5, two memory units M1' and M2' are shown. The N-sense amplifier NSA and the P-sense amplifier PSA are provided adjacent each other and are used in common for both units M1' and M2'. A bit line pair B1 and B1# for the unit M1' is connected to N-sense amplifier NSA and P-sense amplifier PSA through a pair of N-pass transistors T1 and T1#, and a bit line pair B2 and B2# for the unit M2' is connected to N-sense amplifier NSA and P-sense amplifier PSA through a pair of N-pass transistors T2 and T2#. Bit lines B2 and B2# are physically disconnected with bit lines B3 and B3# which form the next memory unit M3'. Although not shown, memory units M3' and M4' are arranged in the same manner as memory units M1' and M2'.

According to the second prior art memory unit array shown in Fig. 6, two memory units M1'' and M2'' are shown. Only the N-sense amplifier NSA is used in common for the both units M1'' and M2''. For the unit memory M1'', a pair of bit lines B1 and B1# is directly connected to P-sense amplifier PSA1 which is in turn connected through a pair of N-pass transistors T1 and T1# to N-sense amplifier NSA. Similarly, for the unit memory M2'', a pair of bit lines B2 and B2# is directly connected to P-sense amplifier PSA2 which is in turn connected through a pair of N-pass transistor T2 and T2# to the N-sense amplifier NSA.

The semiconductor memory unit array shown in Fig. 5 operates as follows. When one word line W11 is selected and made active by the supplied address signal, the accumulated charge in the memory cell M is read out to the bit line B1 to produce a potential difference between the pair of bit lines B1 and B1#. In the meantime, the pass transistors T1 and T1# connected to the bit lines B1 and B1# turned ON to connect the bit lines to sense amplifiers NSA and PSA. At this time, since the pass transistors T2 and T2# are turned OFF, bit lines B2 and B2# are disconnected from sense amplifiers NSA and PSA. Thus, the potential difference between bit line B1 and B1# is amplified in the N-sense amplifier NSA and then the P-sense amplifier PSA such that the higher potential bit line is raised to the power supply voltage level and the lower potential bit line is lowered to the ground level. Thereafter, the data is rewritten to the memory cell M.

The semiconductor memory unit array of Fig. 6 operates in a similar manner to that of Fig. 5.

The problem in the memory unit array of Fig. 5 is such that when HIGH data is transferred from the N-sense amplifier NSA to the either bit line B1 or B1# through the N-pass transistors T1 or T1#, a potential drop equal to the subthreshold voltage of the N-pass transistors T1 or T1# occurs. Thus, it is necessary to boost the gate potential TR1 of the pass transistors T1 and T1# to a level greater than the power supply voltage in order to write the HIGH data sufficiently to the memory cell M. Thus, a booster is necessary for the transistors T1 and T1#.

To maintain the bit line pairs B1-B1# and B2-B2# in an precharge state during the latency time (standby time), all of the pass transistors T1, T1#, T2 and T2# must be maintained turned ON. It is therefore necessary to continue the operation of the booster during the standby time, or to switch the gate potential TR1 in two different levels, one for the standby time and the other for the writing time. Operating the booster during the standby time, however, significantly increases current consumption. In addition, complicated circuitry is required to switch the gate potential TR1 between the standby and writing times.

The memory unit array of Fig. 6 does not require any booster, because the P-sense amplifier PSA1 is directly connected to the bit lines B1 and B1#. However, there is such a problem that the number of P-sense amplifiers PSA increases, resulting in increased size of the memory unit array.

## SUMMARY OF THE INVENTION

Therefore, an object of the present invention is to resolve these problems by providing a semiconductor memory unit array which does not require any booster, and which can use the P- and N-sense amplifiers in common between the neighboring memory units.

To achieve the object, a semiconductor memory unit array according to the present invention comprises a plurality of memory units aligned in an array, each memory unit comprising: a memory cell array having a plurality of pairs of bit lines aligned parallel to each other, a plurality of word lines aligned parallel to each other and orthogonal to the bit lines, and a plurality of memory cells provided at every other intersections of the bit lines and word lines; a plurality of first gate transistors of P-type aligned in an array along a first side of the memory cell array and connected to the bit lines; a plurality of P-sense amplifiers aligned in an array along the first side of the memory cell array each P-sense amplifier connected to one ends of one pair of bit lines through the first gate transistors; a plurality of second gate transistors aligned in an array along a side of the P-sense amplifiers, opposite to a side connected to the first gate transistors, and connected to the P-sense amplifiers; a plurality of third gate transistors of N-type aligned in an array along a second side, opposite to the first side, of the memory cell array; a plurality of N-sense amplifiers aligned in an array along the second side of the memory cell array, each N-sense amplifier connected to other ends of the one pair of bit lines through the third gate transistors; and a plurality of fourth gate transistors of N-type aligned in an array along a side of the N-sense amplifier, opposite to a side connected to the third gate transistors, and connected to the N-sense amplifiers.

The first and second gate transistors and the P-sense amplifier array are used in common with two memory units positioned adjacent P-sense amplifier array, and the third and fourth gate transistors and the N-sense amplifier array are used in common with two memory units positioned adjacent the N-sense amplifier array.

Because the N-sense amplifiers and P-sense amplifiers share the two bit line pairs leading from each side thereof, and the N-sense amplifier and bit line pair are connected through N-pass transistors, and the P-sense amplifier and bit line pair are connected through P-pass transistors, an increase in chip size is suppressed, and HIGH data can be written to the memory cell without applying a boost signal to the pass transistors.

## BRIEF DESCRIPTION OF THE DRAWINGS

The present invention will become more fully understood from the detailed description given below and the accompanying drawings wherein:

Fig. 1 is a diagram of a semiconductor memory unit array according to a preferred embodiment of the present invention;

Fig. 2 is a circuit diagram of a portion of a semiconductor memory unit array of Fig. 1;

Fig. 3 is a timing diagram of the voltage applied to the memory unit of the present invention;

Fig. 4 is a modification of a precharge circuit used in the circuit of Fig. 3;

Fig. 5 is a circuit diagram of a prior art semiconductor memory unit array; and

Fig. 6 is a circuit diagram of another prior art semiconductor memory unit array.

## DESCRIPTION OF PREFERRED EMBODIMENTS

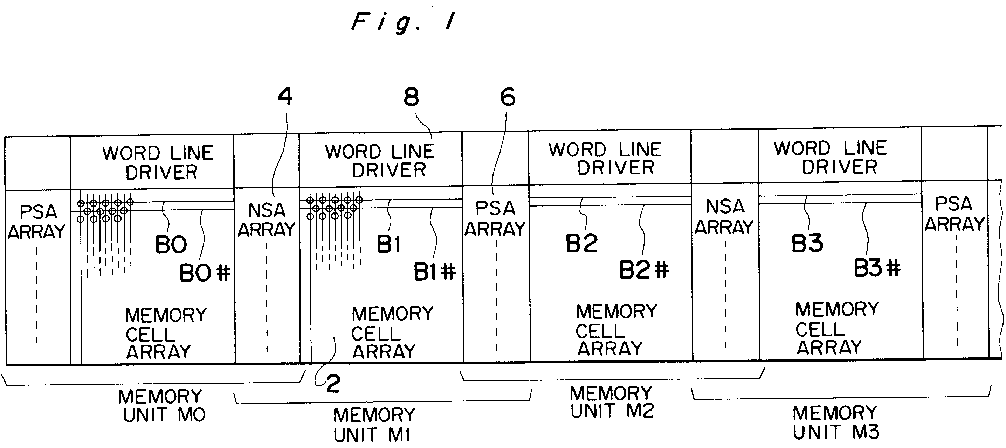

Referring to Fig. 1, a semiconductor memory unit array according to the present invention is shown which includes a plurality of memory units M0, M1, M2, M3, ... One memory unit, such as M1 includes a rectangular cell area 2 which has a plurality of pairs of bit lines, e.g., B1, B1# aligned parallel to each other, a plurality of word lines, e.g., W11, W12 aligned parallel to each other and orthogonal to the bit lines, and a plurality of memory cells M provided at every other intersections of the bit lines and word lines.

One memory unit further has N-sense amplifier array 4 having a plurality of N-sense amplifiers NSA aligned vertically on one side of the cell area 2, P-sense amplifier array 6 having a plurality of P-sense amplifiers PSA aligned vertically on the other side of the cell area 2 opposite to said one side, and word line drive circuit 8 aligned horizontally on one of the two remaining sides of the cell area 2.

Referring to Fig. 2, a memory unit M1 has a plurality of pairs of bit lines, but only one pair of bit lines B1 and B1# is shown. One ends of the pair of bit lines, e.g., B1 and B1# are connected through first gate transistors TP1 and TP1# (P-type) to a P-sense amplifier PSA1. The P-sense amplifier PSA1 is further connected to second gate transistors TP2 and TP2#. The other ends of a pair of bit lines B1 and B1# are connected through third gate transistors TN1 and TN1# (N-type), respectively, to a precharge circuit PC1 and further to an N-sense amplifier NSA1. The N-sense amplifier NSA1 is further connected to fourth gate transistors TN0 and TN0# (N-type). The gates of the first gate transistors TP1 and TP1# are connected to a line for supplying a switching signal TRP1 from a gate control 10. Similarly, gates of other gate transistors are connected to the gate control 10.

The N-sense amplifier NSA1 includes a differential amplifier formed by N-type transistors Tr1 and Tr2 connected in series between bit lines B1 and B1#. The gate of transistor Tr1 is connected to the bit line B1# and the gate of transistor Tr2 is connected to the bit line B1. A junction between the transistors Tr1 and Tr2 is connected to a line for supplying a trigger signal SAN1#.

The precharge circuit PC1 is formed by a transistor Tr3 connected between bit lines B1 and B1#. The gate of transistor Tr3 is connected to a line for supplying a precharge signal PCN1. A modification of the precharge circuit is shown in Fig. 4.

The P-sense amplifier PSA1 includes a differential amplifier formed by P-type transistors Tr4 and Tr5 which are arranged in a similar manner to the transistors provided in N-sense amplifier NSA1. A junction between the transistors Tr4 and Tr5 is connected to a line for supplying a trigger signal SAP1.

The second memory unit M2 has a similar structure to that of the first memory unit M1. The only difference is that the N-sense amplifier and the P-sense amplifier are located at opposite sides of the bit lines.

The P-sense amplifier PSA1 and first and second gate transistors TP1, TP1# and TP2, TP2# provided on opposite sides of P-sense amplifier PSA1 are used in common between memory units M1 and M2. Similarly, the N-sense amplifier NSA3 and the gate transistors provided on opposite sides thereof are used in common between memory units M2 and M3. In this manner, both P- and N-sense amplifiers are shared between neighboring memory units. One precharge circuit PC1 or PC3 is inserted in one pair of bit lines in one memory unit.

When memory unit M1 is taken into consideration, the gate transistors TP1, TP1#, TN1 and TN1# located close to the memory cells turn ON to connect the adjacent sense amplifiers NSA1 and PSA1 with the cells on the bit lines B1 and B1#, while the gate transistors TN0, TN0#, TP2 and TP2# located away from the memory cells turn OFF to isolate the memory unit M1 from the neighboring memory units.

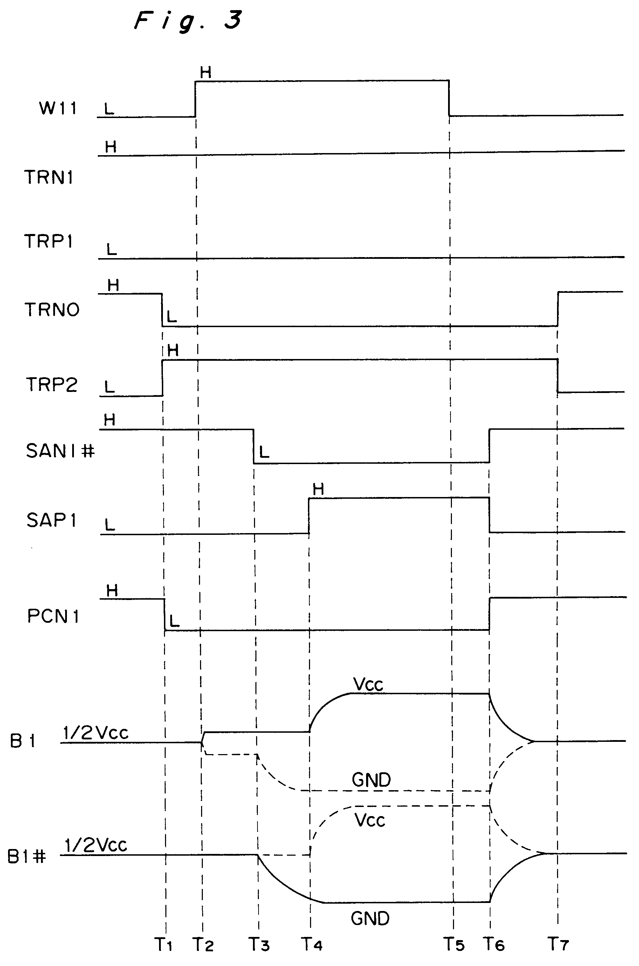

Referring to Fig. 3, the operation of one memory unit M1 is described.

Initially, all of the N-pass transistors TN0, TN0#, TN1 and TN1# are turned ON by HIGH level signals TRN0 and TRN1 so as to connect all of the bit lines B0, B0#, B1 and B1# to the precharge circuit PC1 and further to the N-sense amplifier NSA1. Also, all of the P-pass transistors TP1, TP1# TP2 and TP2# are turned ON by LOW level signals TRP1 and TRP2 so as to connect all of the bit lines B1, B1#, B2 and B2# to the P-sense amplifier PSA1.

At time T1, transistors TN0 and TN0# are turned OFF by a LOW level signal TRN0, and transistors TP2 and TP2# are turned OFF by a HIGH level signal TRP2 so as to isolate the memory unit M1 from the neighboring memory units. Also, at time T1, the precharge signal PCN1 is changed to LOW so that the bit lines B1 and B1# are disconnected.

At time T2, a word line W11 is selected and made active by an address signal supplied from the word line driver so that the charge accumulated in the memory cell M is read and transferred to the bit line B1. Thus, the potential of the bit line B1, initially precharged to ½Vcc, shifts slightly such that if the charge in the memory cell M is positive, the potential increases slightly as shown by a solid line, but if negative, the potential decreases slightly as shown by a dotted line in Fig.3. The description hereinbelow is directed to a case where the memory cell M is charged positive indicated by the solid line.

At time T3, the trigger signal SAN#1 is changed from HIGH to LOW level,to activate the N-sense amplifier NSA1. Since the memory cell M is previously charged positive voltage which is now applied to the bit line B1, the conductivity of transistor Tr2 increases to reduce the potential of the bit line B1# to the LOW level (ground level) as supplied by signal SAN#1.

At time T4, the trigger signal SAP1 is changed from LOW to HIGH level to activate the P-sense amplifier PSA1. At this time, since the bit line B1# is reduced to LOW level, the conductivity of transistor Tr4 increases to increase the potential of the bit line B1 to the HIGH level as supplied by signal SAP1. Thus, after time T4, the data stored in memory cell M is produced between bit lines B1 and B1# such that the bit line B1 is increased to the HIGH level (Vcc level), and the bit line B1# is decreased to LOW level (ground level). The data on the bit lines B1 and B1# is taken out in a known manner before time T5.

At time T5, the signal on the word line W11 is changed to LOW to close the memory cell M.

At time T6, the trigger signals SAN#1 and SAP1 are changed to HIGH and LOW level signals, respectively, to disable the N- and P-sense amplifiers NSA1 and PSA1. Also, the precharge circuit PC1 is activated by the precharge signal PCN1 which is now turned to a HIGH level signal. Thus, after time T6, the bit lines B1 and B1# are set to precharge level (½Vcc).

At time T7, transistors TN0 and TN0# are turned ON by a HIGH level signal TRN0, and transistors TP2 and TP2# are turned ON by a LOW level signal TRP2 so as to dissolve the isolation of the memory unit M1 from the neighboring memory units.

As apparent from the above, because the bit lines B1 and B1# are connected to the N-sense amplifier NSA1 through the N-pass transistors TN1 and TN1#, and also to the P-sense amplifier PSA1 through the P-pass transistors TP1 and TP1#, LOW data is transferred from the N-sense amplifier NSA1 to the bit line B1# through the N-pass transistor TN1#, and HIGH data is transferred from the P-sense amplifier PSA1 to the other bit line B1 through the P-pass transistor TP1. Thus, since there is no potential drop caused by the subthreshold voltage of the pass transistors TN1; TN1#, TP1 and TP1#, it is not necessary to apply the boost potential to the pass transistor gates as is required in the first prior art memory unit array described above in connection with Fig. 5.

When compared with the second prior art memory unit array of Fig. 6, the memory unit array of the present invention enables the number of P-sense amplifiers to be reduced by half, because the P-sense amplifiers are shared between the neighboring memory units in the present invention. In this respect, according to the second prior art shown in Fig. 6, each memory unit has one P-sense amplifier array.

A practical semiconductor memory unit array can be constructed with a simple circuit design according to the present invention because the chip size can be reduced and it is not necessary to apply a booster to the pass transistor gate lines.

The invention being thus described, it will be obvious that the same may be varied in many ways. Such variations are not to be regarded as a departure from the spirit and scope of the invention, and all such modifications as would be obvious to one skilled in the art are intended to be included within the scope of the following claims.

## Claims

1. A semiconductor memory unit array having a plurality of memory units aligned in an array, each memory unit comprising:

   (I) a memory cell array (2) comprising a plurality of pairs of bit lines (B1, B1#) aligned parallel to each other, a plurality of word lines (W11, W12) aligned parallel to each other and orthogonal to said bit lines, and a plurality of memory cells (M) provided at every other intersections of said bit lines and word lines;

   (II) a plurality of first gate transistors (TP1, TP1#) aligned in an array along a first side of said memory cell array and connected to said bit lines (B1, B1#);

   (III) a plurality of P-sense amplifiers (PSA) aligned in an array along said first side of said memory cell array, each P-sense amplifier (PSA1) connected to one ends of one pair of bit lines through said first gate transistors (TP1, TP1#);

   (IV) a plurality of second gate transistors (TP2, TP2#) aligned in an array along a side of said P-sense amplifiers (PSA), opposite to a side connected said first gate transistors (TP1, TP1#), and connected to said P-sense amplifiers (PSA);

   (V) a plurality of third gate transistors (TN1, TN1#) aligned in an array along a second side, opposite to said first side, of said memory cell array;

   (VI) a plurality of N-sense amplifiers (NSA) aligned in an array along said second side of said memory cell array, each N-sense amplifier connected to other ends of said one pair of bit lines through said third gate transistors (TN1, TN1#); and

   (VII) a plurality of fourth gate transistors (TN0, TN0#) aligned in an array along a side of said N-sense amplifiers (NSA), opposite to a side connected to said third gate transistors (TN1, TN1#), and connected to said N-sense amplifiers (NSA);

   said first and second gate transistors and said P-sense amplifier array being used in common with two memory units positioned adjacent said P-sense amplifier array (PSA), and said third and fourth gate transistors and said N-sense amplifier array being used in common with two memory units positioned adjacent said N-sense amplifier array (NSA).

2. A semiconductor memory unit array as claimed in Claim 1 further comprising a gate control means (10) for providing switch signals to said first, second, third and fourth gate transistor arrays such that first and third gate transistor arrays turn on and second and fourth gate transistors arrays turn off to enable access to the memory cells located between said first and third gate transistor arrays,

3. A semiconductor memory unit array as claimed in Claim 1, wherein said first and second gate transistors (TP1, TP1#, TP2, TP2#) are formed by P-type transistors, and wherein said third and fourth gate transistors (TN1, TN1#, TN0, TN0#) are formed by N-type transistors.

4. A semiconductor memory unit array as claimed in Claim 1, each memory unit further comprising a precharge circuit (PC) connected between said one pair of bit lines.

5. A semiconductor memory unit array having a plurality of memory units aligned in an array, each memory unit comprising:

   (I) a rectangular memory cell array (2) having first and second sides opposite to each other, said memory cell array comprising:

      (a) a plurality of pairs of bit lines (B1, B1#) aligned parallel to each other;

      (b) a plurality of word lines (W11, W12) aligned parallel to each other and orthogonal to said bit lines;

      (c) a plurality of memory cells (M) provided at every other intersections of said bit lines and word lines;

   (II) a plurality of first gate P-pass transistors (TP1, TP1#) aligned in an array along said first side of said memory cell array and connected to said bit lines (B1, B1#);

   (III) a plurality of P-sense amplifiers (PSA) aligned in an array along said first side of said memory cell array, each P-sense amplifier comprising:

      (a) a differential amplifier connected to one pair of bit lines through said first gate P-pass transistors (TP1, TP1#) and formed by at least one pair of P-type transistors (Tr4, Tr5);

   (IV) a plurality of second gate P-pass transistors (TP2, TP2#) aligned in an array along a side of said P-sense amplifiers (PSA), opposite to a side connected to said first gate P-pass transistors (TP1, TP1#), and connected to said P-sense amplifiers (PSA);

(V) a plurality of third gate N-pass transistors (TN1, TN1#) aligned in an array along said second side of said memory cell array;

(VI) a plurality of N-sense amplifiers (NSA) aligned in an array along said second side of said memory cell array, each N-sense amplifier comprising:

> (a) a differential amplifier connected to said one pair of bit lines through said third gate N-pass transistors (TN1, TN1#) and formed by at least one pair of N-type transistors (Tr1, Tr2); and

(VII) a plurality of fourth gate N-pass transistors (TN0, TN0#) aligned in an array along a side of said N-sense amplifiers (NSA), opposite to a side connected to said third gate N-pass transistors (TN1, TN1#), and connected to said N-sense amplifiers (NSA);

> said memory unit array further comprising a gate control means (10), for providing trigger signals to said first, second, third and fourth gate transistor arrays such that first and third gate transistor arrays are turned on and second and fourth gate transistors arrays are turned off to enable access to the memory cells located between said first and third gate transistor arrays,

> said first and second gate transistors and said P-sense amplifier array being used in common with two memory units positioned adjacent said P-sense amplifier array (PSA), and said third and fourth gate transistors and said N-sense amplifier array being used in common with two memory units positioned adjacent said N-sense amplifier array (NSA).

6. A semiconductor memory device comprising a series of memory cell arrays, and sets of sense amplifiers, each set being disposed between a respective pair of adjacent memory cell arrays, and being connected via gate transistors to corresponding bit lines of said pair of adjacent memory cell arrays, wherein for each memory cell array the amplifiers on opposite sides thereof connected to the same bit lines are of respective different types adapted to amplify signals having respective polarities.

7. A semiconductor memory device as claimed in claim 6, wherein said respective types of sense amplifiers are N-sense and P-sense amplifiers, and the gate transistors disposed on both sides of each of said sense amplifiers are N-pass transistors for the N-sense amplifiers and are P-pass transistors for the P-sense amplifiers.

Fig. 1

Figure 1: Block diagram showing memory units M0, M1, M2, M3. Each memory unit contains a WORD LINE DRIVER and MEMORY CELL ARRAY, with blocks labeled B0/B0#, B1/B1#, B2/B2#, B3/B3#. Between units are PSA ARRAY and NSA ARRAY sections. Reference numerals: 2, 4, 6, 7, 8.

Fig. 2

EP 0 499 478 A2

# Fig. 3

Fig. 4

Fig. 5    PRIOR ART

EP 0 499 478 A2

Fig. 6 PRIOR ART